Europäisches Patentamt

European Patent Office

Office européen des brevets

(19)

(11) Veröffentlichungsnummer : **0 489 276 B1**

# (12) EUROPÄISCHE PATENTSCHRIFT

(45) Veröffentlichungstag der Patentschrift :
**28.06.95 Patentblatt 95/26**

(51) Int. Cl.$^6$ : **H03C 1/06**

(21) Anmeldenummer : **91119268.0**

(22) Anmeldetag : **12.11.91**

(54) **Modulationseinrichtung für einen Hf-Leistungsverstärker.**

(30) Priorität : **03.12.90 DE 4038534**

(43) Veröffentlichungstag der Anmeldung :
**10.06.92 Patentblatt 92/24**

(45) Bekanntmachung des Hinweises auf die
Patenterteilung :
**28.06.95 Patentblatt 95/26**

(84) Benannte Vertragsstaaten :
**BE DE ES FR GB IT**

(56) Entgegenhaltungen :
**EP-A- 0 271 703**
**US-A- 4 561 111**
**US-A- 4 939 483**

(73) Patentinhaber : **SIEMENS**
**AKTIENGESELLSCHAFT**
**Wittelsbacherplatz 2**
**D-80333 München (DE)**

(72) Erfinder : **Wendt, Peter, Dipl.-Ing.**
**Oblatterwallstrasse 36c**
**W-8900 Augsburg (DE)**
Erfinder : **Friedrich, Gerold, Dipl.-Ing.**
**Gardolostrasse 6**
**W-8056 Neufahrn (DE)**

EP 0 489 276 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf eine Modulationseinrichtung gemäß dem Oberbegriff des Patentanspruchs 1.

Die Erfindung geht von Pulsleistungsverstärkern unter Verwendung von Hf-Leistungstransistoren aus, wobei während der Verstärkung von Hf-Impulsen auf eine hohe Ausgangsleistung gleichzeitig eine Pulsformung entsprechend einer vorgegebenen Hüllkurve vorgenommen werden soll und die Pulsspitzenleistung einen gewünschten Wert annehmen soll.

Einer der wesentlichen Nachteile von Hf-Leistungstransistoren ist die bei Pulsbetrieb entstehende nichtlineare Verzerrung der Pulsform der Ausgangsleistung. Dieses Problem ist z.B. aus der DE-C-29 04 011 bekannt.

Die Erzeugung von Sendepulsen mit definierter Hüllkurve stellt grundsätzlich eine Amplitudenmodulation dar. In der DE-C-28 35 751 wird erwähnt, daß die bekannte Lehre zur Regelung des Modulationssignals nicht ohne weiteres auf Hf-Leistungsverstärker, bei denen die Hf-Trägerschwingung mit Impulsen moduliert wird, übertragen werden kann. Dies gilt insbesondere dann, wenn die Impulse nur eine kurze Impulsdauer, z.B. 8 µsec, haben. Die bei der bekannten Regelung benötigte Zeit ist für diese Anwendungsfälle zu lang.

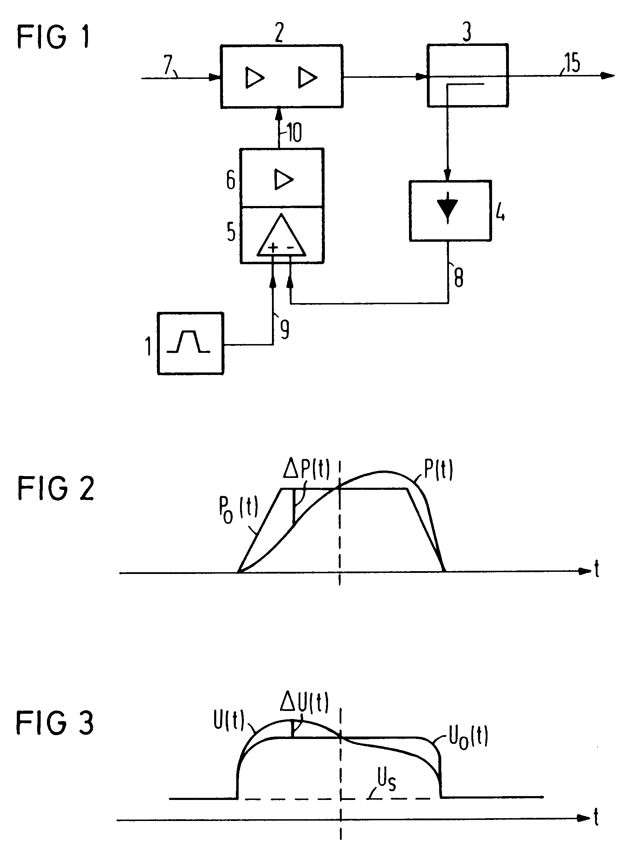

Es ist allgemein bekannt, daß die Linearität bei der Verstärkung durch Anwendung der negativen Rückkopplung (Gegenkopplung) verbessert werden kann. Im Aufsatz von J. Stammelbach: "Probleme bei der Amplitudenmodulation von Transistorleistungsstufen" aus "Frequenz", Juni 76, Band 30, Nr. 6, Seiten 136 bis 144, ist eine Möglichkeit zur Linearisierung der Pulsform bei Hf-Leistungsverstärkern angegeben, die mit Hüllkurvengegenkopplung bezeichnet wird. Anhand von Fig. 1 wird diese Linearisierungsmöglichkeit erläutert. Einem Hf-Verstärker 2 wird ein Hf-Eingangssignal 7 zugeführt. Der in einer Auskoppeleinrichtung 3 abgezweigte und mittels eines Demodulators 4 demodulierte Teil des Hf-Ausgangspulses 15 wird als Istpuls 8 in einem Komparator 5 mit einem von einem Pulsgenerator 1 stammenden Sollpuls 9 verglichen. Die Abweichung wird durch entsprechendes Steuern der Modulationssteuerspannung 10 bis auf eine Restabweichung ausgeregelt, die von der Regelverstärkung einer Bewertungsschaltung 6 abhängt.

Aus der bereits erwähnten DE-C-28 35 751 ist ein Hf-Leistungsverstärker bekannt, bei dem ein Teil des modulierten Verstärkerausgangssignals abgenommen, gleichgerichtet und mit dem Soll-Modulationssignal verglichen wird und bei dem entsprechend dem Vergleichsergebnis das tatsächliche Modulationssignal so vorverzerrt wird, daß das Verstärkerausgangssignal den gewünschten Verlauf hat.

In der DE-C-32 21 911 wird darauf hingewiesen, daß bei dem bekannten Hf-Leistungsverstärker zur Anpassung des Ist- an den Soll-Impuls ein großer Zeitaufwand notwendig ist, wenn das Ist- vom Soll-Signal zu Beginn der Korrektur zu stark abweicht. Dies ist häufig dann der Fall, wenn von einer ersten auf eine zweite Trägerfrequenz umgeschaltet wird.

Aus der DE-C-32 91 911 ist im einzelnen ein Hf-Leistungsverstärker bekannt, bei dem durch Verwendung von Zwischenspeichern die Korrektur in den Sendepausen durchgeführt wird. In diesem Fall ist die Regelschleife während der Korrektur unterbrochen. Bei dem dort beschriebenen Sender wird nach dem Sendevorgang von der Betriebsart "Senden" auf die Betriebsart "Korrigieren" umgeschaltet. Dabei wird davon ausgegangen, daß das Sendesignal relativ lange Pausen zwischen den Sendeimpulsen oder den Impulsgruppen besitzt, wie dies beim Entfernungsmeßsystem DME oder dem Navigationssystem TACAN der Fall ist.

Bei bestimmten Anwendungen der Hf-Leistungsverstärker besteht die Pulsfolge aus 100 und mehr Pulsen je Nachricht, wobei zwischen zwei Pulsen die Möglichkeit der Umschaltung auf eine andere Trägerfrequenz und von einem ersten auf ein zweites Pulsformat besteht. In diesen Fällen gelingt es mit Hilfe des beschriebenen Verstärkers aus zeitlichen Gründen nicht, das Modulationssignal geeignet vorzuverzerren, da zur Korrektur alle Soll- und Ist-Amplitudenwerte aller Impulse einer Impulsgruppe miteinander verglichen werden müßten.

Aus der DE-C-29 04 011, die ebenfalls bereits erwähnt wurde, ist ein Hochfrequenzimpulsverstärker bekannt, bei dem eine Verstärkerkette mittels einer AGC-Regelschleife auf eine konstante Ausgangsleistung geregelt wird. Jeder der Transistor-Verstärkerstufen ist eine Konstantstromquelle zugeordnet. Die Steuerimpulse für alle Konstantstromquellen laufen über eine gemeinsame Impulsformerschaltung und werden bezüglich ihrer Spannungsamplitude eingestellt, und zwar von einer AGC-Regelspannung, die in Abhängigkeit von der gesamten Ist-Ausgangsleistung der Verstärkerstufen im Vergleich zur konstant zu haltenden Soll-Ausgangsleistung gewonnen wird. Die Flanken der von der Pulsformerschaltung abgegebenen Impulse, welche die Konstantstromquellen steuern, richten die Flanken der die Verstärkerstufen durchlaufenden Hochfrequenzimpulse aus und können je nach Anforderung ausgebildet werden.

Die hierbei vorgesehene AGC-Regelschleife regelt die Ausgangsleistung der Verstärkerstufen in Abhängigkeit von der Amplitudenänderung der Hüllkurve. Die Zeitkonstante bei einer AGC-Schaltung wird stets so groß gewählt, daß aus den aufeinander folgenden Hochfrequenzimpulsen eine mittlere Gleichspannung gebildet wird, deren Wert damit der Amplitude der Hf-Impulse proportional ist. Auf dieses Problem wird in der DE-C-12 97 703 eingegangen. Durch entsprechende Wahl der Zeitkonstante der Gleichrichterschaltung kann aus dem Verstärkerausgangssignal die Hüllkurve der Hochfrequenzimpulse gewonnen werden.

Aus dem Aufsatz von D. Graziani: "Solid State Amplifiers for DME-Beacons" in der Zeitschrift "Electrical Communication", Vol. 50, Nr. 4, 1975, Seiten 273 bis 277 ist ein Transistor-Leistungsverstärker für DME-Anwendungen bekannt, bei welchem der Modulationssteuerpuls einen "Sockel" aufweist. Der Grund für diese Modulationstechnik liegt in der anfänglichen Nichtlinearität der Steuerkennlinie zwischen der Ausgangsleistung und der Modulationspulsamplitude. Die Nichtlinearität bei niedriger Modulationsspannung bewirkt eine Änderung der Pulsform durch eine Verkürzung der Anstiegs- und Abfallzeiten. Die hierin angegebene Modulationstechnik mittels Vorverzerrung des Modulationssteuerpulses hat den Nachteil, ein reiner Steuerungsvorgang zu sein. Thermisch bedingte oder frequenzabhängige Änderungen der Verstärkerkennlinie während der Pulsaussendung beeinflussen die Pulsform und die Ausgangsleistung in unerwünschter Weise. Es ist denkbar, die nichtlineare Verstärkerkennlinie in ihrer Temperatur- und Frequenzabhängigkeit zu erfassen und dies bei der Formung des Modulationssteuerpulses zu berücksichtigen. In der Praxis ergeben sich Abweichungen von der idealen Form der Modulationssteuerpulse bereits durch den Meßfehler bei der Bestimmung der nichtlinearen Verstärkerkennlinie oder durch Exemplarstreuungen oder durch eine durch Alterungseffekte bedingte Degradation im Betrieb. Eine Einwirkung auf das Modulationssteuersignal in Abhängigkeit vom Verstärkerausgangssignal wäre nur durch einen Regelungsvorgang in Form einer negativen Rückkopplung zu erreichen.

Puls-Leistungsverstärker, die bis in den GHz-Bereich Pulsspitzenleistungen von 200 W und mehr erzeugen, verwenden HF-Leistungstransistoren für Pulsbetrieb. Die Transistoren arbeiten dabei im nichtlinearen C-Betrieb und werden nur während der Tastung in den A- und B-Betrieb gesteuert (DE-C-29 04 011). Bei derartigen Verstärkern besteht eine nichtlineare Kennlinie zwischen der Modulationssteuerspannung und der abgegebenen Pulsausgangsleistung. Unterhalb einer "Anlaufspannung" des Verstärkers ist die Ausgangsleistung Null, steigt dann z.B. nach einer quadratischen Funktion an und erreicht bei einer bestimmten Modulationssteuerspannung einen Sättigungswert. Eine nichtlineare Kennlinie ergibt sich auch für den in DE-C-29 04 011 angegebenen Hf-Impulsverstärker mit Steuerung durch Konstantstromquellen, und zwar dann, wenn nicht jeder der Transistor-Verstärkerstufen eine Konstantstromquelle zugeordnet werden kann. Dies ist z.B. dann der Fall, wenn minimale mechanische Abmessungen gefordert sind oder die Endstufentransistoren mehr als 10 A benötigen oder die in den Konstantstromquellen umgesetzte Verlustleistung aufgrund eines Tastverhältnisses von 20 % nicht sicher abgeführt werden kann.

Eine Pulsformung mit einer Regelschleife entsprechend Fig. 1 ist bei derartigen HF-Leistungsverstärkern mit nichtlinearer Steuerkennlinie prinzipiell nicht möglich. Wegen der ausgeprägten Nichtlinearität bei kleinen Modulationsspannungen tritt nicht nur im "Pulsfuß" eine starke nichtlineare Verzerrung der Ausgangspulsform auf. Insbesondere ist die Ausgangsleistung als Funktion der Zeit solange Null, bis die Modulationssteuerspannung den Wert der "Anlaufspannung" des Verstärkers erreicht hat. Dieser Effekt bewirkt eine zeitliche Verzögerung zwischen den ansteigenden Flanken des Modulationssteuerpulses und des Ausgangspulses. Die daraus resultierende Totzeit des Verstärkers wird dabei umso größer, je langsamer die Modulationssteuerspannung als Funktion der Zeit ansteigt. Bei Pulsformen mit Anstiegszeiten in der Größenordnung 1 μsec treten daher Verkürzungen der Ausgangspulsform auf, die auch durch einen beliebig schnellen Regelalgorithmus nicht zu korrigieren sind, da die erfaßte Regelgröße während der Totzeit Null ist.

Aufgabe der Erfindung ist es, eine Maßnahme für die Modulationseinrichtung eines Hf-Leistungsverstärkers anzugeben, durch welche gewährleistet ist, daß auch bei Pulsformaten, bei denen die Zeit zwischen der Aussendung zweier Sendeimpulse extrem kurz ist und kein längerer Zeitabschnitt zur Anpassung der Ausgangspulse an die gewünschte Soll-Pulsform zur Verfügung steht, der Hf-Ausgangspuls des Hf-Leistungsverstärkers nahezu unverzerrt diese vorgegebene Pulsform aufweist.

Diese Aufgabe wird bei einer gattungsgemäßen Modulationseinrichtung durch die im kennzeichnenden Teil des Patentanspruchs 1 angegebenen Merkmale gelöst.

Die Erfindung geht davon aus, den Hf-Leistungsverstärker mit seiner Modulationssteuerstufe als Regelstrecke zu linearisieren. Diese Linearisierung wird aus dem bereits ausgeführten Grund nicht als ein Regelungsvorgang mit negativer Rückkopplung, sondern als ein Steuerungsvorgang realisiert. Eine Linearisierung des Hf-Verstärkers ergibt sich in der Weise, daß aus der nichtlinearen Steuerkennlinie eine Korrektur des Modulationspulses so bestimmt wird, daß die durch die nichtlineare Steuerkennlinie verursachte Einwirkung auf die gewünschte Ausgangspulsform und -leistung zunächst ohne Eingriff des Reglers ausgeglichen wird. Dies entspricht regelungstechnisch der Linearisierung um einen festen Betriebszustand, wobei dieser feste Wert den gewünschten Betriebszustand des Systems bezeichnet.

Zweckmäßige Weiterbildungen der Erfindung sind in den Unteransprüchen angegeben.

Die Erfindung und Weiterbildungen davon werden im folgenden anhand von Zeichnungen erläutert. Es zeigen

Fig. 1      das bereits beschriebene Blockschaltbild einer bekannten Hüllkurven-Gegenkopplungsschaltung,

Fig. 2 und Fig. 3      die Leistung bzw. die Spannung betreffende Impulsformen der Hüllkurve und des Modulationssteuerpulses,

Fig. 4      das Blockschaltbild eines Ausführungsbeispiels einer Modulationseinrichtung nach der Erfindung,

Fig. 5      ein Schaltungsbeispiel einer Bewertungsschaltung in Form eines PI-Reglers.

Im vorliegenden Fall soll nach Fig. 2 die zeitveränderliche Hüllkurve der Ausgangsleistung eine gewünschte Pulsform mit vorgegebener Pulsspitzenleistung annehmen, und die Regelung soll das Einhalten dieser Pulsform garantieren. Ist $P(t)$ die zeitverändliche Hüllkurve, $P_o(t)$ ihre gewünschte Pulsform und $\Delta P(t)$ die Abweichung der Hüllkurve von der gewünschten Pulsform, dann ist

$$P(t) = P_o(t) + \Delta P(t).$$

Der gewünschten Pulsform $P_o(t)$ entspricht ohne Störeinwirkung eine Pulsform $U_o(t)$ der Modulationssteuerspannung (Fig. 3). Treten durch auf den Verstärker einwirkende Störungen (z.B. Temperatur- und Frequenzänderungen oder Alterungseffekte) Änderungen der Steuerkennlinie oder Hf-Verstärkung und demzufolge Abweichungen der Pulsform und -leistung auf, so ist es Aufgabe der Regelung, diese Abweichungen während der Pulsaussendung auszugleichen und die Modulationssteuerspannung $U_o(t)$ im Sinne einer negativen Rück-kopplung um $\Delta U(t)$ so zu ändern, daß die Abweichung $\Delta P(t)$ verringert wird. Dieses Verhalten der Regelung ist in Fig. 2 bzw. 3 beispielhaft dargestellt für einen trapezförmigen Hüllkurvenimpuls $P_o(t)$ und einen Modula-tionssteuerimpuls $U_o(t)$ entsprechend einer quadratischen Kennlinie des Hf-Verstärkers mit einer "Anlaufspan-nung" $U_s$.

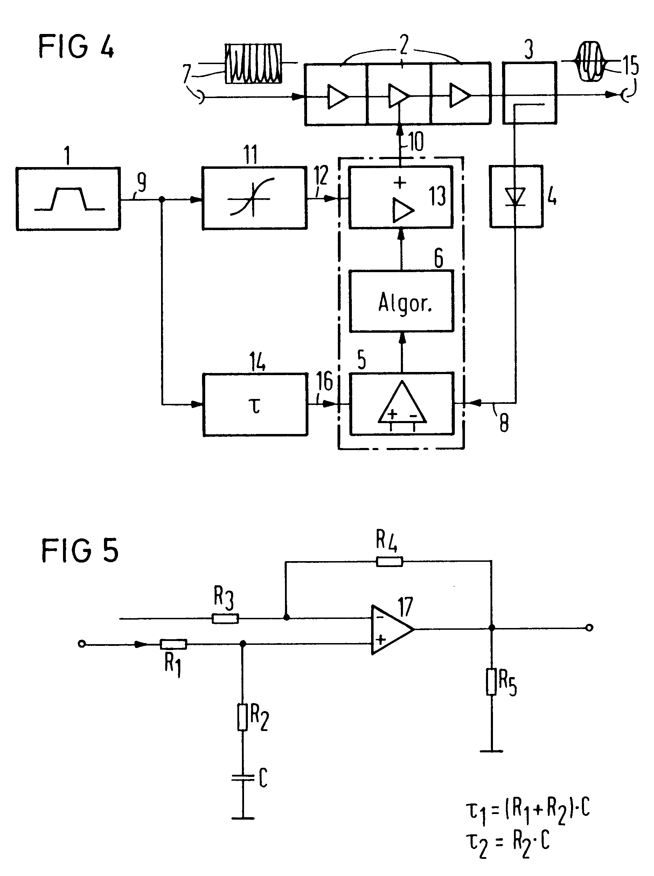

Unter Einwirkung von Störungen würde sich bei reiner Steuerung oder offener Regelschleife und unver-ändertem Modulationssteuerpuls $U_o(t)$ ein von $P_o(t)$ abweichender Hüllkurvenpuls $P(t)$ einstellen. Bei geschlossener Regelschleife ergibt sich über den Reglereingriff ein geänderter Modulationssteuerpuls $U(t)$, der wieder den Hüllkurvenpuls $P_o(t)$ bis auf eine Restabweichung erzwingt. Erweitert man aufgrund dieser Überlegungen den Prinzipaufbau des Regelkreises in Fig. 1 um einen zusätzlichen Steuerpuls zur Linearisierung des Hf-Verstärkers, so ergibt sich der in Fig. 4 dargestellte Regelkreis mit modifizierter Modulatorschaltung nach der Erfindung.

Gegenüber der Darstellung in Fig. 1 ergibt sich folgender Aufbau:

Der vom Pulsgenerator 1 abgegebene Sollpuls 9 wird in einer Linearisierungsschaltung 11 entsprechend der Steuerkennlinie des Hf-Leistungsverstärkers 2 korrigiert und als Steuerpuls 12 über einen ersten Eingang eines Summierverstärkers 13 dem Modulationseingang des Hf-Leistungsverstärkers 2 zugeführt.

Bedingt durch die endliche Modulationsbandbreite und Ladungstransporteffekte in den Hf-Leistungstransistoren tritt auf dem Wege zwischen dem Modulationssteuerpuls 10 zum Ausgangs-Hüllkurvenpuls 15 eine unvermeidliche Signallaufzeit ("Modulatorlaufzeit") $\tau m$ auf. Während dieser Laufzeit ist die erfaßte Regelgröße (Istpuls 8) noch Null, und es liegt ein reiner Steuerungsvorgang des Ausgangspulses durch den Modulationssteuerpuls 10 vor. Der Soll/Istwert-Vergleich in einem den Komparator 5 bildenden Differenzverstärker des Modulators kann erst nach der Modulatorlaufzeit $\tau m$ mit dem um die gleiche Laufzeit in einem Laufzeitglied 14 verzögerten Referenzpuls 16 erfolgen. Der Regelungsvorgang setzt also erst mit der Zeitverzögerung $\tau m$ ein.

Das Ausgangssignal des Differenzverstärkers 5 (Regelabweichung) wird in einer Bewertungsschaltung 6 (Regler) mit einem Regelalgorithmus bewertet und von dort über den zweiten Eingang an den Summierverstärker 13 geführt; im Summierverstärker 13 wird es dann zum Steuerpuls 12 am ersten Eingang addiert.

Bei der Wahl des Regelalgorithmus ist das Ziel, einerseits eine hohe Regelgenauigkeit und andererseits im Hinblick auf die unvermeidliche Modulatorlaufzeit $\tau m$ eine kurze Einstellzeit des Regelkreises zu erhalten. Die Regelgenauigkeit läßt sich erhöhen, wenn man die Verstärkung des Reglers zu tiefen Frequenzen ansteigen läßt. Diese Anforderung erfüllt eine Reglerschaltung, die eine Ausgangsspannung der Form

$$U_a = K_R \cdot X_d + K_R \cdot \frac{1}{T_i} \cdot \int X_d \, dt$$

liefert (PI-Regler).

$K_R$: = Proportionalverstärkung, $X_d$: = Regelabweichung, $T_i$: = Integrationszeit.

Mit dem Integralanteil ist eine drastische Verkürzung der Einstellzeit des Regelkreises verbunden. Dies rührt daher, daß die maximal mögliche Proportionalverstärkung eines P-Reglers (wegen der auftretenden Stabilitätsprobleme) so niedrig ist, daß die Vollaussteuerung der Regelstrecke auch bei großen Abweichungen nicht erreicht wird. Ist ein Integralanteil vorhanden, so summiert sich bei größeren Abweichungen schnell eine so große Ausgangsspannung auf, daß eine Vollaussteuerung der Regelstrecke auftritt. Daher kann ein Integralanteil auch dann vorteilhaft sein, wenn gar keine hohe Abgleichgenauigkeit sondern eine kurze Einstellzeit von Bedeutung ist.

Die Reglercharakteristik ist im Hinblick auf die Modulatorlaufzeit $\tau m$ zu bemessen. Infolge der Modulatorlaufzeit wirkt sich eine Korrektur des Modulationssteuerpulses erst verspätet auf den Ausgangspuls aus, wodurch ein instabiles Verhalten der Regelschleife auftreten kann.

Die Integrationszeit $T_i$ des PI-Reglers ist mindestens gleich der Modulatorlaufzeit $\tau m$ zu dimensionieren und sollte maximal etwa 1 Dekade über $\tau m$ liegen. Damit wird die Grenzfrequenz $\omega_2$ des PI-Reglers, bei der die Integrationswirkung der Schaltung in ein proportionales Übertragungsverhalten übergeht, vergleichbar mit dem Kehrwert der Modulatorlaufzeit. Die Verstärkung des PI-Reglers bei hohen Frequenzen ist im Hinblick auf die Referenzpulsform so zu bemessen, daß der Regler Regelabweichungen genügend schnell auf Null bringen kann.

Bei einer praktischen Ausführung des PI-Reglers läßt sich vorteilhaft eine Regelschaltung nach Fig. 5 verwenden. Dabei ist ein Operationsverstärker 17 vorgesehen, dem an seinem +-Eingang über ein Widerstands-Kondensatornetzwerk R1, R2, C das Eingangssignal eingegeben und der über ein Widerstandsspannungsteilernetzwerk $R_3$, $R_4$, $R_5$ vom Ausgang her gegengekoppelt ist. Der Operationsverstärker 17 hat die zwei Zeitkonstanten $\tau_1 = (R_1 + R_2) C$ und $\tau_2 = R_2 . C$. Die gewählte Realisierung entspricht im Übertragungsverhalten dem idealen PI-Regler mit den beiden Einschränkungen, daß oberhalb der Grenzfrequenz $\omega_3$ die Bandbegrenzung durch den verwendeten Operationsverstärker einsetzt (überlagertes Tiefpaßverhalten) und unterhalb der Grenzfrequenz $\omega_1$ die Verstärkung des Reglers auf einen konstanten Wert begrenzt wird. Diese Maßnahme wurde eingeführt, um die Schleifenverstärkung des Regelkreises im quasistationären Zustand z.B. während des Pulsdaches bei trapezförmigen Sollpulsen im Hinblick auf den Aussteuerbereich des Reglers zu begrenzen.

Für das Regelverhalten der geschlossenen Schleife ist es entscheidend, ob die Anstiegszeit der jeweiligen Flanken des Pulsformats deutlich größer oder eher vergleichbar ist mit der Modulatorlaufzeit $\tau m$. Im ersten Fall - hierzu gehört beispielsweise das TACAN-Pulsformat - kann die Regelung nicht nur den Spitzenwert der Leistung wirksam korrigieren, sondern auch den Verlauf der Flanken und der Pulsbreite im Sinne des Referenzpulses.

Im zweiten Fall, in dem der Einfluß der Modulatorlaufzeit $\tau m$ ins Gewicht fällt, kann lediglich eine Regelung der Pulsamplitude im Pulsdach erfolgen, da der Eingriff der Regelung laufzeitbedingt zu spät erfolgt, um für die Flanken noch korrigierend wirken zu können.

## Patentansprüche

1. Modulationseinrichtung für einen mit einem oder mehr Hf-Leistungstransistoren versehenen Hf-Leistungsverstärker (2), aus dessen verstärktem und moduliertem Hf-Ausgangssignal ein kleiner Teil ausgekoppelt und demoduliert und als demodulierter Hüllkurven-Istpuls mit dem von einem Pulsgenerator (1) abgegebenen Soll-Modulationspuls in einem Komparator (5) verglichen wird, dessen Vergleichsergebnis als Modulationssteuerpuls zur Modulation herangezogen wird,
**dadurch gekennzeichnet,**
daß der Pulsgenerator (1) in einem Nebenausgangszweig noch an eine Linearisierungsschaltung (11) angeschlossen ist, in welcher der vom Pulsgenerator abgegebene Sollpuls (9) entsprechend der Steuerkennlinie des Hf-Leistungsverstärkers (2) korrigiert wird, daß der in der Linearisierungschaltung korrigierte Puls als Steuerpuls (12) einem ersten Eingang eines Summierverstärkers (13) zugeführt wird, dessen zweitem Eingang das Vergleichsergebnis aus dem Komparator (5) über eine Bewertungsschaltung (6) zugeleitet wird, die nach Art eines Reglers eine Bewertung mit einem Regelalgorithmus durchführt, daß der dem Pulsgenerator entnommene Sollimpuls (9) in seinem Zuführungsweg zum Komparator noch über ein Laufzeitglied (14) geführt wird, dessen Laufzeit der im wesentlichen durch die Hf-Leistungstransistoren im Hf-Leistungsverstärker bedingten Signallaufzeit ($\tau m$) vom Modulationssteuerpuls (10) zum Ausgangs-Hüllkurven-Istpuls (8) des Hf-Leistungsverstärkers entspricht, und daß das Ausgangssignal des Summierverstärkers als Modulationssteuerpuls (10) dem Hf-Leistungsverstärker zugeführt wird.

2. Modulationseinrichtung nach Anspruch 1,
**dadurch gekennzeichnet,**
daß die Bewertungsschaltung (6) den Regelalgorithmus eines Proportional-Integral(PI)-Reglers ausführt.

**3.** Modulationseinrichtung nach Anspruch 2,
**dadurch gekennzeichnet,**
daß die Integrationszeit des PI-Reglers (6) mindestens so lange wie die Signallaufzeit ($\tau$m) bemessen ist und maximal etwa eine Dekade über der Signallaufzeit ($\tau$m) liegt.

**4.** Modulationseinrichtung nach einem der Ansprüche 1 bis 3,
**dadurch gekennzeichnet,**
daß der Sollpuls (9) einem programmierbaren Speicher für digitale Signale entnommen wird.

**5.** Modulationseinrichtung nach einem der vorhergehenden Ansprüche,
**dadurch gekennzeichnet,**
daß sowohl der Steuerpuls (12) als auch der verzögerte Referenzpuls (16) je einem programmierbaren Speicher für digitale Signale entnommen werden.

**6.** Modulationseinrichtung nach Anspruch 1,
**dadurch gekennzeichnet,**
daß als Komparator (5) ein Differenzverstärker vorgesehen ist.

## Claims

**1.** Modulation device for an RF power amplifier (2) provided with one or more RF power transistors, from the amplified and modulated RF output signal of which amplifier a small part is coupled out and demodulated and is compared as a demodulated envelope actual pulse with the desired modulation pulse, emitted by a pulse generator (1), in a comparator (5), the comparison result of which is used as a modulation control pulse for modulation, characterized in that the pulse generator (1) in an auxiliary output branch is additionally connected to a linearization circuit (11), in which the desired pulse (9), emitted by the pulse generator, is corrected in accordance with the control characteristic of the RF power amplifier (2), in that the pulse, corrected in the linearization circuit, is fed as a control pulse (12) to a first input of a summing amplifier (13), to the second input of which there is forwarded the comparison result from the comparator (5) via a weighting circuit (6), which carries out weighting, in the manner of a controller, using a control algorithm, in that the desired pulse (9), which is taken from the pulse generator and fed to the comparator, is additionally passed, en route, via a delay element (14), the delay time of which corresponds to the signal delay time ($\tau$m) from the modulation control pulse (10) to the output envelope actual pulse (8) of the RF power amplifier, which signal delay time is caused essentially by the RF power transistors in the RF power amplifier, and in that the output signal of the summing amplifier is fed as a modulation control pulse (10) to the RF power amplifier.

**2.** Modulation device according to Claim 1, characterized in that the weighting circuit (6) executes the control algorithm of a proportional-integral (PI) controller.

**3.** Modulation device according to Claim 2, characterized in that the integration time of the PI controller (6) is dimensioned so that it is at least as long as the signal delay time ($\tau$m) and is at most approximately one decade above the signal delay time ($\tau$m).

**4.** Modulation device according to one of Claims 1 to 3, characterized in that the desired pulse (9) is taken from a programmable memory for digital signals.

**5.** Modulation device according to one of the preceding claims, characterized in that both the control pulse (12) and the delayed reference pulse (16) are each taken from a programmable memory for digital signals.

**6.** Modulation device according to Claim 1, characterized in that a differential amplifier is provided as the comparator (5).

## Revendications

**1.** Dispositif de modulation pour un amplificateur de puissance haute fréquence (2) muni d'un ou de plusieurs transistors de puissance haute fréquence, une petite partie du signal de sortie haute fréquence amplifié et modulé de cet amplificateur en étant découplée et démodulée et cette partie étant comparée, en tant qu'impulsion réelle d'enveloppe, avec l'impulsion de modulation de consigne, qui est fournie par un générateur d'impulsions (1), dans un comparateur (5), dont le résultat de comparaison est utilisé pour la modulation en tant qu'impulsion de commande de modulation,

caractérisé par le fait que,

le générateur d'impulsions (1), dans une branche de sortie secondaire, est connecté à un circuit de linéarisation (11), dans lequel l'impulsion de consigne (9) qui est fournie par le générateur d'impulsions est corrigée en fonction de la caractéristique de commande de l'amplificateur de puissance haute fréquence (2), que l'impulsion (12) corrigée dans le circuit de linéarisation est envoyée en tant qu'impulsion de commande à une première entrée d'un amplificateur sommateur (13), dont la deuxième entrée reçoit le résultat de comparaison venant du comparateur (5) par l'intermédiaire d'un circuit de pondération (6), qui effectue, comme un régulateur, une pondération par un algorithme de régulation, que l'impulsion de consigne (9) extraite du générateur d'impulsions passe, sur son chemin menant au comparateur, par un circuit à retard (14), dont le temps de retard correspond au temps ($\tau$m) de retard des signaux, dû surtout aux transistors de puissance haute fréquence dans l'amplificateur de puissance haute fréquence, de l'impulsion de commande de modulation (10) à l'impulsion réelle d'enveloppe de sortie (8) de l'amplificateur de puissance haute fréquence, et que le signal de sortie de l'amplificateur sommateur est envoyé en tant qu'impulsion de commande de modulation (10) à l'amplificateur de puissance haute fréquence.

2. Dispositif de modulation selon la revendication 1,

caractérisé par le fait que,

le circuit de pondération (6) effectue l'algorithme de régulation d'un régulateur proportionnel intégral (PI).

3. Dispositif de modulation selon la revendication 2,

caractérisé par le fait que,

le temps d'intégration du régulateur PI (6) est au moins aussi long que le temps ($\tau$m) de retard des signaux et qu'il se situe au maximum environ une décade au-dessus du temps ($\tau$m) de retard des signaux.

4. Dispositif de modulation selon l'une des revendications 1 à 3,

caractérisé par le fait que,

l'impulsion de consigne (9) peut être extraite d'une mémoire programmable servant à des signaux numériques.

5. Dispositif de modulation selon l'une des revendications précédentes,

caractérisé par le fait que,

aussi bien l'impulsion de commande (12) que l'impulsion de référence (16) retardée sont extraites chacune d'une mémoire programmable pour des signaux numériques.

6. Dispositif de modulation selon la revendication 1,

caractérisé par le fait que,

l'on prévoit en tant que comparateur (5) un amplificateur de différence.

FIG 1

FIG 2

FIG 3

**FIG 4**

**FIG 5**

$$\tau_1 = (R_1 + R_2) \cdot C$$
$$\tau_2 = R_2 \cdot C$$